# EUROPÄISCHE PATENTSCHRIFT

(11) **EP 3 724 037 B1**
(45) Veröffentlichungstag und Bekanntmachung des Hinweises auf die Patenterteilung: **06.09.2023**
(21) Anmeldenummer: 18819038.3
(22) Anmeldetag: 06.12.2018
(51) Int. Cl.: B60R 16/02, B60R 16/03, H01L 25/16, H05K 1/02, H05K 3/46, H02M 3/335, H02J 1/08, H03K 17/689

(54) **BESTÜCKTE PLATINE FÜR EIN ELEKTRISCHES BORDNETZ EINES KRAFTFAHRZEUGS**
BOARD FOR ELECTRICAL NETWORK OF A VEHICLE
PLAQUE POUR LE RÉSEAU ÉLECTRIQUE D'UN VÉHICULE

(30) Priorität: 13.12.2017 DE 102017222592
(43) Veröffentlichungstag der Anmeldung: 21.10.2020
(73) Patentinhaber: Mahle International GmbH, 70376 Stuttgart (DE)
(72) Erfinder: BIELESCH, Thomas, 75417 Mühlacker (DE); BÖHM, Michael, Kanagawa-ken, Kanagawa 224--0012 (JP); STASCH, Wojciech, 70499 Stuttgart (DE)
(74) Vertreter: BRP Renaud & Partner mbB Rechtsanwälte Patentanwälte Steuerberater
(86) Internationale Anmeldenummer: PCT/EP2018/083813
(87) Internationale Veröffentlichungsnummer: WO 2019/115349

(56) Entgegenhaltungen:
- EP-A2- 1 447 280
- WO-A2-2011/078404
- DE-A1-102012 105 513
- JP-A- H11 176 479
- JP-A- 2009 232 637
- US-A1- 2005 231 925
- US-A1- 2009 243 764
- US-A1- 2010 202 124
- US-A1- 2016 226 392

## Beschreibung

Die vorliegende Erfindung betrifft eine bestückte Platine für ein elektrisches Bordnetz eines Kraftfahrzeugs.

Das Bordnetz eines Kraftfahrzeugs beinhaltet sämtliche elektrischen Komponenten des Kraftfahrzeugs, wie z.B. Steuergeräte, Sensoren, Batteriesysteme und Anzeigeelemente, beispielsweise Displays und Warnleuchten. Durch sich ständig weiterentwickelnde Komfortsysteme, wie z.B. bessere Klimaanlagen oder im Kraftfahrzeug angeordnete Displays für Unterhaltungselektronik, ist das Bordnetz eines modernen Kraftfahrzeugs stetig steigenden Belastungen ausgesetzt. Besonders im Winter bei niedrigen Temperaturen ist das Bordnetz auch ohne die Komfortsysteme einer höheren Belastung ausgesetzt. Grundsätzlich bekannt sind Bordnetze mit relativ niedriger Spannung, z.B. 12 Volt, die im vorliegenden Zusammenhang auch als Niedervolt-Spannung bezeichnet werden kann, oder mit etwas höherer Spannung, z.B. 48 Volt, die im vorliegenden Zusammenhang auch als Hochvolt-Spannung bezeichnet werden kann. Ein duales Bordnetz arbeitet mit zwei verschiedenen Spannungen, also sowohl mit der niedrigeren Spannung als auch mit der höheren Spannung, oder anders gesagt, das duale Bordnetz arbeitet mit Niedervolt-Spannung und mit Hochvolt-Spannung. Die Hochvolt-Spannung ist im vorliegenden Zusammenhang keine Hochspannung, die definitionsgemäß mindestens 1.000 Volt beträgt, sondern liegt in der Regel unter 100 Volt, vorzugsweise bei ca. 48 Volt.

Der Einsatz eines reinen 12V Bordnetzes ist nachteilig, da ein 12V Bordnetz kaum in der Lage ist, den Strombedarf zu decken, der für den Betrieb der grundlegenden Systeme, wie z.B. Scheinwerfer, bzw. der für den Betrieb moderner Komfortsysteme nötig ist. Ferner muss berücksichtigt werden, dass sich der Trend stetig weiterentwickelnder Komfortsysteme auch in der Zukunft fortsetzten wird, wodurch es notwendig ist, Bordnetze bereits in der Gegenwart auf die zukünftigen Anforderungen auszulegen. Jedoch sind reine 48V Bordnetze teuer in der Herstellung, wodurch der Einsatz von reinen 48V Bordnetzen in Kraftfahrzeugen in einem deutlich höheren Endpreis des Kraftfahrzeugs resultiert, den potentielle Kunden nur bedingt bereit sind zu zahlen. Deshalb werden reine 12V Bordnetze bevorzugt auf duale 12V/48V Bordnetze umgestellt, anstatt Kraftfahrzeuge mit einem kostspieligen 48V Bordnetz auszustatten. Die Umstellung eines reinen 12V Bordnetzes auf ein duales 12V/48V Bordnetz ist mit hohem Zeitaufwand und Kosten verbunden. Die Architektur einer Platine eines 12V Bordnetzes sollte im Idealfall bereits für das zukünftig verwendete duale 12V/48V Bordnetz ausgelegt sein, um den Zeitaufwand und die Kosten bei der Umstellung eines 12V Bordnetzes auf ein duales 12V/48V Bordnetz zumindest zu reduzieren.

Aus der DE 10 2012 105 513 A1 ist ein Hybridschaltkreis bekannt, der auf einer Hauptplatine einen Niederspannungskreis und auf einer Zusatzplatine einen Hochspannungskreis aufweist. Die separate Zusatzplatine ist auf die Hauptplatine aufgesetzt. Der Hochspannungskreis ist über eine auf der Hauptplatine angeordneten Schnittstelle mit dem Niederspannungskreis gekoppelt.

Weitere Hybridschaltkreise sind in der US 2009/243764 A1, der WO 2011/078404 A2, der US 2005/231925 A1 sowie der EP 1 447 280 A2 beschrieben.

Die vorliegende Erfindung beschäftigt sich daher mit dem Problem, für eine bestückte Platine für ein elektrisches Bordnetz eine verbesserte oder zumindest alternative Ausführungsform anzugeben, welche es ermöglicht, die Platine sowohl mit einer niedrigen Bordnetzspannung als auch mit einer hohen Bordnetzspannung zu betreiben.

Dieses Problem wird erfindungsgemäß durch den Gegenstand des unabhängigen Anspruchs gelöst. Vorteilhafte Ausführungsformen sind Gegenstand der abhängigen Ansprüche.

Die vorliegende Erfindung beruht auf dem allgemeinen Gedanken, eine bestückte Platine für ein elektrisches Bordnetz mit einem zusammenhängenden Platinenkörper bereitzustellen, auf dem elektronische Leistungskomponenten, die eine Leistungsschaltung bilden, und elektronische Steuerkomponenten, die eine Steuerschaltung bilden, angeordnet und miteinander verschaltet sind. Die Platine fungiert dabei als Träger für elektronische Bauteile und dient der mechanischen Befestigung und der elektrischen Verbindung dieser Bauteile. Hierzu können die Bauteile unmittelbar mit der Platine bzw. mit integrierten Leiterbahnen der Platine verlötet sein. Dabei sind die Leistungskomponenten in einem zusammenhängenden bzw. kontinuierlichen Leistungsbereich und die Steuerkomponenten in einem zusammenhängenden bzw. kontinuierlichen Steuerbereich angeordnet. Der Leistungsbereich weist erste Stromanschlüsse auf, über welche die Leistungsschaltung mit Strom versorgt werden kann und der Steuerbereich weist zweite Stromanschlüsse auf, über welche die Steuerschaltung mit Strom versorgt werden kann. Die zweiten Stromanschlüsse sind ferner dazu ausgebildet, die Steuerschaltung anzusteuern. Mit einer erfindungsgemäßen Platine, die eine räumlich getrennten Anordnung des Leistungsbereichs und des Steuerbereichs bzw. der Leistungsschaltung und der Steuerschaltung besitzt, ist es einfach möglich, die Platine sowohl in einem herkömmlichen reinen 12V Bordnetz als auch in einem dualen 12V/48V Bordnetz zu betreiben. Wird die Platine in einem dualen, z.B. 12V/48V, Bordnetz betrieben, wird die Steuerschaltung dabei mit einer relativ niedrigen Bordnetzspannung, z.B. 12V, und die Leistungsschaltung mit einer relativ hohen Bordnetzspannung, z.B. 48V, betrieben. Wird die Platine in einem herkömmlichen, z.B. 12V Bordnetz betrieben, so werden sowohl die Steuerschaltung als auch die Leistungsschaltung mit einer niedrigen Bordnetzspannung betrieben. Die Verwendung einer solchen Platine ist vorteilhaft, da es dadurch möglich ist, ein reines 12V Bordnetz ohne großen Aufwand und ohne große Kosten auf ein duales 12V/48V Bordnetz umzurüsten.

Auf dem Platinenkörper ist, zusätzlich zu dem Leistungsbereich und dem Steuerbereich, ein zusammenhängender bzw. kontinuierlicher Kopplungsbereich ausgebildet. Der Kopplungsbereich weist Anschlüsse für wenigstens eine elektrische Kopplungskomponente auf, wobei die Kopplungskomponente zum elektrischen Koppeln der Steuerschaltung mit der Leistungsschaltung ausgebildet ist. Dadurch ist ermöglicht, die Steuerschaltung und die Leistungsschaltung trotz der separaten Anordnung des Steuerbereichs und des Leistungsbereichs durch Anordnen wenigstens einer Kopplungskomponente an den Anschlüssen elektrisch miteinander zu koppeln.

Ferner ist erfindungsgemäß vorgesehen, dass auf dem Platinenkörper durch den Kopplungsbereich verlaufende Kopplungsleiterbahnen zum elektrischen Koppeln der Steuerschaltung mit der Leistungsschaltung ausgebildet sind. Ist an den Anschlüssen keine Kopplungskomponente angeordnet, so ist es durch die Leiterbahnen ermöglicht, die Steuerschaltung mit der Leistungsschaltung zu koppeln, wodurch es wiederum ermöglicht ist, die Platine in einem herkömmlichen 12V Bordnetz zu betreiben. Da die Leiterbahnen bereits auf dem Platinenkörper ausgebildet sind, sind keine weiteren Montageschritte notwendig, um die Steuerschaltung mit der Leistungsschaltung zu koppeln. Es ist auch denkbar, dass die Kopplungsleiterbahnen am Rand der Platine bzw. am Rand des Platinenkörpers ausgebildet sind.

Weiter erfindungsgemäß ist vorgesehen, dass an die Anschlüsse im Kopplungsbereich keine Kopplungskomponente angeschlossen ist, die Steuerschaltung durch die Kopplungsleiterbahnen mit der Leistungsschaltung gekoppelt ist und dass die Leistungsschaltung und die Steuerschaltung für eine Stromversorgung mit einem gemeinsamen Spannungsniveau ausgestaltet sind. Anders formuliert: das gemeinsame Spannungsniveau und die Bauteile der Leistungsschaltung bzw. die Bauteile der Steuerschaltung müssen so gewählt werden, dass die Bauteile der Steuerschaltung nicht durch ein zu großes Spannungsniveau beschädigt werden und dass das Spannungsniveau trotzdem ausreichend groß ist, um die Bauteile der Leistungsschaltung zu betreiben. Dementsprechend ist es zweckmäßig, wenn die Leistungsschaltung nur Bauteile aufweist, für deren Betrieb lediglich eine verhältnismäßig niedrige Spannung notwendig ist und wenn die Steuerschaltung nur Bauteile aufweist, die mit dem gleichen Spannungsniveau betrieben werden können, wie die Bauteile der Leistungsschaltung.

Gemäß einem nicht erfindungsgemäßen Beispiel kann vorgesehen sein, dass an die Anschlüsse im Kopplungsbereich wenigstens eine Kopplungskomponente angeschlossen ist, durch welche die Steuerschaltung mit der Leistungsschaltung gekoppelt ist. Dabei sind die in die Platine integrierten Kopplungsleiterbahnen, insbesondere durch mechanische, chemische oder thermische Bearbeitung, unterbrochen, wobei die Leistungsschaltung für eine Stromversorgung mit einem höheren Spannungsniveau ausgestaltet ist, während die Steuerschaltung für eine Stromversorgung mit einem niedrigeren Spannungsniveau ausgestaltet ist. Dementsprechend dienen die ersten Stromanschlüsse als Hochvoltanschlüsse und die zweiten Stromanschlüsse als Niedervoltanschlüsse. Es ist denkbar, dass die Steuerschaltung anfangs über die Kopplungsleiterbahnen mit der Leistungsschaltung verbunden ist und dass die Platine in einem herkömmlichen 12V Bordnetz mit gleichem Spannungsniveau für die Leistungsschaltung und die Steuerschaltung betrieben wird. Anschließend wird es durch Unterbrechen der Kopplungsleiterbahnen und Anschließen wenigstens einer Kopplungskomponente an den Anschlüssen des Kopplungsbereichs ermöglicht, die Platine in einem dualen 12V/48V Bordnetz zu betreiben. Dies ist vorteilhaft, da es dadurch ermöglicht ist, ein Kraftfahrzeug, in welchem die Platine angeordnet ist, von einem 12V Bordnetz auf ein duales 12V/48V Bordnetz umzurüsten, ohne die Platine auszutauschen, wodurch Zeit und Kosten gespart werden können. Ferner kann dieselbe Platine in einer Standardversion in einem einfachen Bordnetz betrieben werden, während sie für das duale Bordnetz nur geringfügig modifiziert werden muss, beispielsweise, indem die Kopplungsleiterbahnen unterbrochen und die wenigstens eine Kopplungskomponente eingebaut wird. Somit lassen sich große Stückzahlen realisieren, welche die Stückpreise reduzieren.

Gemäß einem nicht erfindungsgemäßen Beispiel ist vorgesehen, dass die jeweilige elektrische Kopplungskomponente so ausgestaltet ist, dass sie die mit niedriger Spannung betriebene Steuerschaltung galvanisch getrennt mit der mit hoher Spannung betriebenen Leistungsschaltung elektrisch koppelt. Da die Platine sowohl einen Leistungsbereich als auch einen Steuerbereich aufweist, ist es zweckmäßig, dass das elektrische Potential der im Leistungsbereich angeordneten Leistungsschaltung und das elektrische Potential der im Steuerbereich angeordneten Steuerschaltung galvanisch voneinander getrennt sind. Um den Steuerbereich und den Leistungsbereich galvanisch voneinander zu trennen, wird die elektrische Leitung zwischen den Steuerkomponenten und den Leistungskomponenten durch die jeweilige elektrisch nicht leitfähige Kopplungskomponente unterbrochen. Trotzdem ist es notwendig, dass die Steuerschaltung mit der Leistungsschaltung Signale austauschen kann. Dementsprechend ist es denkbar, zum Koppeln der Steuerschaltung mit der Leistungsschaltung einen Opto-Koppler als Kopplungskomponente zu verwenden. Ein Opto-Koppler ermöglicht es, Signale zwischen der Steuerschaltung und der Leistungsschaltung zu übertragen, obwohl die Steuerschaltung von der Leistungsschaltung galvanisch getrennt ist. Ein Opto-Koppler weist ein Sendebauteil und ein Empfängerbauteil auf, welche untereinander optisch gekoppelt sind. Ferner sind kapazitive und induktive Koppler bekannt, die als Kopplungskomponente verwendet werden können. Es ist auch möglich, dass die jeweilige Kopplungskomponente ein Transformator ist, welcher Signale zwischen der Steuerschaltung und der Leistungsschaltung überträgt.

Vorteilhaft kann vorgesehen sein, dass der Kopplungsbereich einerseits direkt an den Leistungsbereich und andererseits direkt an den Steuerbereich angrenzt.

Gemäß einem nicht erfindungsgemäßen Beispiel kann vorgesehen sein, dass die jeweilige Kopplungskomponente zum Koppeln der Steuerschaltung mit der Leistungsschaltung ausgebildet ist. Die jeweilige Kopplungskomponente überträgt Signale zwischen der Steuerschaltung und der Leistungsschaltung. Grenzt der Kopplungsbereich mit der im Kopplungsbereich angeordneten Kopplungskomponente einerseits direkt an den Leistungsbereich und andererseits direkt an den Steuerbereich an, so ist dies vorteilhaft, da es dadurch einfacher ist, die Steuerschaltung mit der Leistungsschaltung zu koppeln bzw. da es dadurch einfacher ist, Signale zwischen der Steuerschaltung und der Leistungsschaltung zu übertragen. Ferner ist es einfacher, die Steuerschaltung durch die insbesondere durch den Kopplungsbereich verlaufenden Kopplungsleiterbahnen mit der Leistungsschaltung zu koppeln, wenn der Kopplungsbereich sowohl an den Leistungsbereich als auch an den Steuerbereich angrenzt.

In weiterer Ausgestaltung der Erfindung kann vorgesehen sein, dass die ersten Stromanschlüsse und die zweiten Stromanschlüsse in einem zusammenhängenden Anschlussbereich nebeneinander angeordnet sind. Der Anschlussbereich erstreckt sich dabei teilweise in den Leistungsbereich und teilweise in den Steuerbereich. Der zusammenhängende Anschlussbereich vereinfacht die Leitungsführung an bzw. auf der Platine und vereinfacht das Anschließen der Platine an eine Stromversorgung mit Niedervoltbereich und Hochvoltbereich.

Zweckmäßig kann ferner vorgesehen sein, dass der Anschlussbereich in einem Randbereich des Platinenkörpers angeordnet ist. Die sich im Anschlussbereich befindenden ersten Stromanschlüsse bzw. die sich im Anschlussbereich befindenden zweiten Stromanschlüsse müssen durch wenigstens ein Anschlusselement mit Strom versorgt werden. Das Anschlusselement wird zumeist händisch mit den ersten bzw. zweiten Stromanschlüssen verbunden. Eine Platine ist nach der Montage in einem Bordnetz üblicherweise in einem Gehäuse angeordnet. Durch die seitliche oder randseitige Anordnung des Anschlussbereichs lässt sich das Anschlusselement leicht mit den ersten bzw. zweiten Stromanschlüssen verbinden.

Vorzugsweise kann ferner vorgesehen sein, dass der Kopplungsbereich an seinem vom Anschlussbereich entfernten Ende an den Steuerbereich und/oder an den Leistungsbereich angrenzt. Durch diese Maßnahme befindet sich der Kopplungsbereich zwischen dem Anschlussbereich und dem Steuerbereich bzw. dem Leistungsbereich.

Eine weitere mögliche Ausführungsform schlägt vor, dass der Steuerbereich für ein Niedervolt-Bordnetz ausgelegt ist, dessen Nennspannung maximal 19 Volt oder maximal 15 Volt beträgt. Durch das Niedervolt-Bordnetz können alle Komponenten, welche nur eine geringe Leistungsaufnahme benötigen, mit Strom versorgt werden. Da die Nennspannung maximal 19 Volt beträgt, ist es durch das Niedervolt-Bordnetz möglich, Komponenten zu betreiben, welche ausschließlich für den Betrieb bei einer Nennspannung von unter 19 Volt geeignet sind und bei einer höheren Nennspannung beschädigt werden. Ferner benötigen viele Komponenten beim Betrieb nur eine geringe Leistung, wodurch es zweckmäßig ist, diese Komponenten mit einer Nennspannung von maximal 19 Volt zu betreiben, um einen energieeffizienten Betrieb dieser Komponenten zu ermöglichen.

Bei einer weiteren vorteilhaften Ausführungsform kann vorgesehen sein, dass der Leistungsbereich für ein Hochvolt-Bordnetz ausgelegt ist, dessen Nennspannung mindestens 40 Volt oder mindestens 45 Volt beträgt. Der Leistungsbereich, dessen Nennspannung minimal 40 Volt beträgt, bildet eine Art zweites Teilbordnetz, welcher das Niedervolt-Bordnetz ergänzt. Eine höhere Spannung ermöglicht den Betrieb der Komponenten, welche eine höhere Leistungsaufnahme benötigen, z.B. den Betrieb einer Vorrichtung für einen beschleunigten Start der Brennkraftmaschine oder den Betrieb eines elektrischen Turboladers.

Grundsätzlich kann vorgesehen sein, dass der Platinenkörper im Leistungsbereich Kupferelemente aufweist. Insbesondere die Leistungskomponenten erhitzen sich beim Betrieb, wobei eine Erhitzung der Leistungskomponenten in einer Beschädigung und einer Beeinträchtigung der Funktion der Leistungskomponenten resultieren kann. Die beim Betrieb der Leistungskomponenten entstehende Wärme muss dementsprechend abgeführt werden, wodurch es vorteilhaft ist, wenn der Platinenkörper im Leistungsbereich Kupferelemente aufweist, da es die Kupferelemente ermöglichen, Wärme effizient abzuführen. Der Platinenkörper bildet eine Wärmesenke für sämtliche auf der Platine angeordnete Komponenten, durch welche die beim Betrieb der Komponenten entstehende Wärme abgeführt wird. Grundsätzlich kann vorgesehen sein, dass nur im Leistungsbereich solche Kupferelemente vorgesehen sind. Da sich die Steuerkomponenten beim Betrieb nicht so stark erhitzen wie die Leistungskomponenten, sind Kupferelemente im Steuerbereich nicht zwingend erforderlich. Es verlässt den Rahmen der vorliegenden Erfindung jedoch nicht, wenn der Platinenkörper auch im Steuerbereich Kupferelemente aufweist.

Die Erfindung betrifft zweckmäßigerweise eine unbestückte Platine zum Herstellen einer bestückten Platine der vorstehend beschriebenen Art. Zweckmäßigerweise kann die bestückte und/oder die unbestückte Platine zur Verwendung in einem Niedervolt-Bordnetz adaptiert werden, so dass im Betrieb der bestückten Platine die ersten Stromanschlüsse des Leistungsbereichs und die zweiten Stromanschlüsse des Steuerbereichs mit einer relativ niedrigen Spannung, z.B. 12V, versorgt werden. Gemäß einem nicht erfindungsgemäßen Beispiel lässt sich die bestückt und/oder unbestückte Platine zur Verwendung in einem ein Niedervolt-Bordnetz und ein Hochvolt-Bordnetz umfassenden dualen Bordnetz adaptieren, so dass im Betrieb der bestückten Platine die ersten Stromanschlüsse des Leistungsbereichs mit einer relativ hohen Spannung, z.B. 48V, versorgt werden, während die zweiten Stromanschlüsse des Steuerbereichs mit einer relativ niedrigen Spannung, z.B. 12V, versorgt werden. Gemäß einem nicht erfindungsgemäßen Beispiel ist vorgesehen, dass sich die für die Verwendung im dualen Bordnetz adaptierte Platine von der für die Verwendung im Niedervolt-Bordnetz adaptierte Platine dadurch unterscheidet, dass bei der für die Verwendung im dualen Bordnetz adaptierte Platine die weiter oben genannten Kopplungsleiterbahnen im bestückten und im unbestückten Zustand unterbrochen sind. Insbesondere unterscheidet sich die unbestückte, für die Verwendung im dualen Bordnetz adaptierte Platine ausschließlich durch die unterbrochenen Kopplungsleiterbahnen von der unbestückten, für die Verwendung im Niedervolt-Bordnetz adaptierten Platine.

Erläutert werden soll auch ein nicht erfindungsgemäßes Verfahren zur Herstellung einer bestückten Platine der vorstehend beschriebenen Art, bei dem es möglich ist, die Steuerschaltung mittels Kopplungsleiterbahnen mit der Leistungsschaltung zu koppeln, bei dem es jedoch auch möglich ist, die Kopplungsleiterbahnen, insbesondere durch mechanische, chemische oder thermische Bearbeitung, zu unterbrechen und die Steuerschaltung durch Anschließen wenigstens einer Kopplungskomponente an die Anschlüsse im Kopplungsbereich mit der Leistungsschaltung zu koppeln. Es gibt dementsprechend zwei Varianten der Platine, die bis auf die unterbrochenen Kopplungsleiterbahnen in einer der beiden Varianten identisch sind.

Weitere wichtige Merkmale und Vorteile der Erfindung ergeben sich aus den Unteransprüchen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

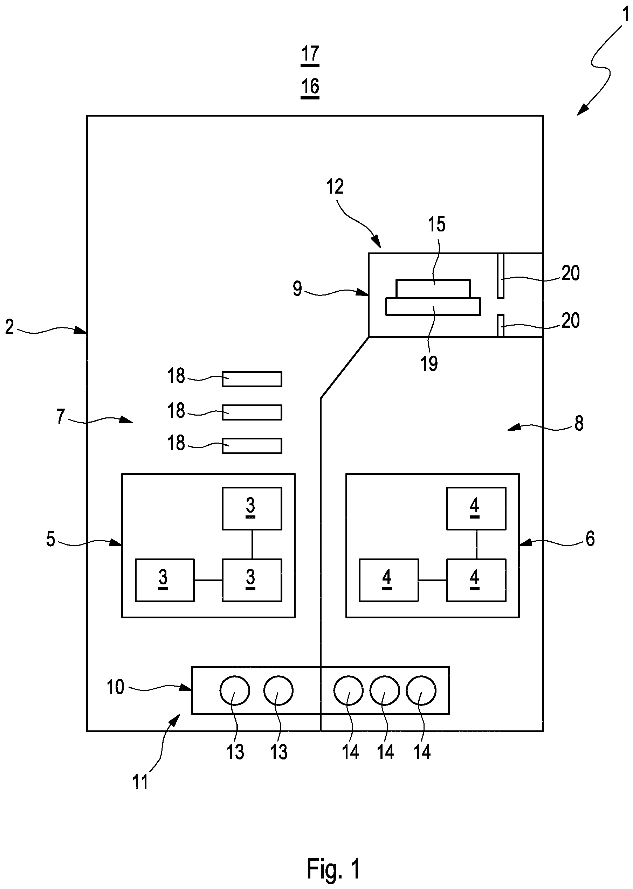

Die einzige Figur 1 zeigt in einer stark vereinfachten schematischen Darstellung eine nicht erfindungsgemäße bestückte Platine mit einer unterbrochenen Kopplungsleiterbahn.

Entsprechend Fig. 1 weist eine nicht erfindungsgemäße bestückte Platine 1 einen zusammenhängenden, einstückigen Platinenkörper 2 auf, wobei auf dem Platinenkörper 2 elektronische Leistungskomponenten 3 und elektronische Steuerkomponenten 4 miteinander elektrisch verschaltet sind. Dabei bilden die Leistungskomponenten 3 eine Leistungsschaltung 5 und die Steuerkomponenten 4 eine Steuerschaltung 6. In Fig. 1 sind rein exemplarisch drei Leistungskomponenten 3 und drei Steuerkomponenten 4 gezeigt, welche die Leistungsschaltung 5 und die Steuerschaltung 6 bilden. Es verlässt den Rahmen der vorliegenden Erfindung selbstverständlich nicht, wenn die Leistungsschaltung 5 mehr oder weniger Leistungskomponenten 3 und die Steuerschaltung 6 mehr oder weniger Steuerkomponenten 4 aufweist. Der Platinenkörper 2 weist einen Leistungsbereich 7, einen Steuerbereich 8, einen Kopplungsbereich 9 und einen Anschlussbereich 10 auf. Ferner werden ein Randbereich des Platinenkörpers 2 mit 11 und ein von diesem Randbereich 11 entferntes oder abgewandtes Ende des Kopplungsbereichs 9 mit 12 bezeichnet. Dabei ist der Leistungsbereich 7 als zusammenhängender Bereich ausgebildet, in dem alle Leistungskomponenten 3 angeordnet sind. Der Platinenkörper 2 kann im Leistungsbereich 7 außerdem Kupferelemente 18 aufweisen, die eine effiziente Abfuhr der von den Leistungskomponenten 3 emittierten Wärme ermöglichen. Der Steuerbereich 8 bildet einen zusammenhängenden Bereich, in dem alle Steuerkomponenten 4 angeordnet sind. Im Leistungsbereich 7 sind erste Stromanschlüsse 13 und im Steuerbereich 8 sind zweite Stromanschlüsse 14 angeordnet, wobei die ersten Stromanschlüsse 13 zur Stromversorgung der Leistungsschaltung 5 und die zweiten Stromanschlüsse 14 zur Stromversorgung der Steuerschaltung 6 ausgebildet sind. Die zweiten Stromanschlüsse 14 sind ferner zum Ansteuern der Steuerschaltung 6 ausgebildet.

Wie in Fig. 1 illustriert, ist auf dem Platinenkörper 2 eine durch den Kopplungsbereich 9 verlaufende Kopplungsleiterbahn 20 zum elektrischen Koppeln der Steuerschaltung 6 mit der Leistungsschaltung 5 ausgebildet. Die Kopplungsleiterbahn 20 ist in Fig. 1 unterbrochen, wodurch ein Koppeln der Steuerschaltung 6 mit der Leistungsschaltung 5 über die Kopplungsleiterbahn 20 nicht möglich ist. Die eine in Fig. 1 gezeigte Kopplungsleiterbahn 20 ist lediglich beispielhaft zu verstehen, es ist zweckmäßig, dass mehrere Kopplungsleiterbahnen 20 auf dem Platinenkörper 2 ausgebildet sind. Es ist ebenso denkbar, dass die Kopplungsleiterbahnen 20 an anderer Stelle als in Fig. 1 gezeigt auf dem Platinenkörper 2 verlaufen. Im Kopplungsbereich 9 ist ein Anschluss 19 ausgebildet, an dem in Fig. 1 eine Kopplungskomponente 15 angeschlossen ist, durch welche die Steuerschaltung 6 mit der Leistungsschaltung 5 gekoppelt ist. Der eine Anschluss 19 bzw. die eine Kopplungskomponente 15 sind auch hier lediglich beispielhaft zu verstehen, es können auch mehrere Anschlüsse 19 und mehrere Kopplungskomponenten 15 vorgesehen sein. Es ist denkbar, dass die Kopplungsleiterbahn 20 durch mechanische, chemische oder thermische Bearbeitung unterbrochen ist. Bei dem in Fig. 1 gezeigten Aufbau der Platine 1 kann die Leistungsschaltung 5 mit einem höheren Spannungsniveau und die Steuerschaltung 6 mit einem niedrigeren Spannungsniveau betrieben werden, so dass die ersten Stromanschlüsse 13 als Hochvoltanschlüsse und die zweiten Stromanschlüsse 14 als Niedervoltanschlüsse dienen können.

Alternativ ist es ebenso möglich, dass an dem Anschluss 19 keine Kopplungskomponente 15 angeschlossen ist und dass die Kopplungsleiterbahn 20 nicht unterbrochen ist, wodurch die Steuerschaltung 6 durch die Kopplungsleiterbahn 20 mit der Leistungsschaltung 5 gekoppelt ist. In dieser Ausführungsform ist die Leistungsschaltung 5 und die Steuerschaltung 6 für eine Stromversorgung mit einem gemeinsamen Spannungsniveau auszugestalten.

Die Kopplungskomponente 15 ist so ausgestaltet, dass sie die Steuerschaltung 6 galvanisch getrennt mit der Leistungsschaltung 5 koppelt. Der Kopplungsbereich 9 bildet dabei, wie der Steuerbereich 8 und der Leistungsbereich 7, einen zusammenhängenden Bereich, wobei der Kopplungsbereich 9 einerseits direkt an den Leistungsbereich 7 und andererseits direkt an den Steuerbereich 8 angrenzt. Der ebenso zusammenhängende Anschlussbereich 10 erstreckt sich teilweise in den Leistungsbereich 7 und teilweise in den Steuerbereich 8. Die ersten Stromanschlüsse 13 und die zweiten Stromanschlüsse 14 sind in dem Anschlussbereich 10 nebeneinander angeordnet. Beispielsweise können die ersten Stromanschlüsse 13 und die zweiten Stromanschlüsse 14 in einer Reihe geradlinig nebeneinander angeordnet sein. Der Anschlussbereich 10 ist in dem Randbereich 11 des Platinenkörpers 2 und der Kopplungsbereich 9 in einem vom Anschlussbereich 10 entfernten Bereich des Platinenkörpers 2 angeordnet. Das vom Randbereich 11 entfernte Ende 12 des Kopplungsbereichs 9 grenzt direkt an den Leistungsbereich 7 an, während ein dem Randbereich 11 zugewandtes Ende des Kopplungsbereichs 9 direkt an den Steuerbereich 8 angrenzt.

Die bestückte Platine 1 kann in einem herkömmlichen 12V Bordnetz eines Kraftfahrzeugs 17 Anwendung finden, wobei die Steuerschaltung 6 und die Leistungsschaltung 5 bei gleichem Spannungsniveau betrieben werden.

Die bestückte Platine 1 kann auch in einem dualen elektrischen Bordnetz 16 Anwendung finden, wobei der Steuerbereich 8 für ein Niedervolt-Bordnetz ausgelegt ist, dessen Nennspannung maximal 19 Volt beträgt. Der Leistungsbereich 7 ist in diesem Fall für ein Hochvolt-Bordnetz ausgelegt, dessen Nennspannung minimal 40 Volt beträgt.

## Patentansprüche

1. Bestückte Platine (1) für ein elektrisches Bordnetz (16) eines Kraftfahrzeugs (17),
- mit einem zusammenhängenden Platinenkörper (2), auf dem elektronische Leistungskomponenten (3), die eine Leistungsschaltung (5) bilden, und elektronische Steuerkomponenten (4), die eine Steuerschaltung (6) bilden, angeordnet und miteinander verschaltet sind,
- wobei auf dem Platinenkörper (2) ein zusammenhängender Leistungsbereich (7), in dem alle Leistungskomponenten (3) angeordnet sind, und ein zusammenhängender Steuerbereich (8) ausgebildet sind, in dem alle Steuerkomponenten (4) angeordnet sind,
- wobei auf dem Platinenkörper (2) außerdem ein zusammenhängender Kopplungsbereich (9) ausgebildet ist, in dem Anschlüsse (19) für wenigstens eine elektrische Kopplungskomponente (15) zum elektrischen Koppeln der Steuerschaltung (6) mit der Leistungsschaltung (5) vorgesehen sind,
- wobei auf dem Platinenkörper (2) Kopplungsleiterbahnen (20) zum elektrischen Koppeln der Steuerschaltung (6) mit der Leistungsschaltung (5) ausgebildet sind,
- wobei die Kopplungsleiterbahnen (20) durch den Kopplungsbereich (9) hindurch verlaufen,
**dadurch gekennzeichnet, dass**
- erste Stromanschlüsse (13) zur Stromversorgung der Leistungsschaltung (5) im Leistungsbereich (7) angeordnet sind,
- zweite Stromanschlüsse (14) zur Stromversorgung und zum Ansteuern der Steuerschaltung (6) im Steuerbereich (8) angeordnet sind,
- an die Anschlüsse (19) im Kopplungsbereich (9) keine Kopplungskomponente (15) angeschlossen ist und die Steuerschaltung (6) durch die Kopplungsleiterbahnen (20) mit der Leistungsschaltung (5) gekoppelt ist,
- die Leistungsschaltung (5) und die Steuerschaltung (6) für eine Stromversorgung mit einem gemeinsamen Spannungsniveau ausgestaltet sind.

2. Bestückte Platine (1) nach Anspruch 1,
**dadurch gekennzeichnet,**
**dass** der Kopplungsbereich (9) einerseits direkt an den Leistungsbereich (7) und andererseits direkt an den Steuerbereich (8) angrenzt.

3. Bestückte Platine (1) nach Anspruch 1 oder 2,
**dadurch gekennzeichnet,**
**dass** die ersten Stromanschlüsse (13) und die zweiten Stromanschlüsse (14) in einem zusammenhängenden Anschlussbereich (10) nebeneinander angeordnet sind, der sich teilweise im Leistungsbereich (7) und teilweise im Steuerbereich (8) erstreckt.

4. Bestückte Platine (1) nach Anspruch 3,
**dadurch gekennzeichnet,**
**dass** der Anschlussbereich (10) in einem Randbereich (11) des Platinenkörpers (2) angeordnet ist.

5. Bestückte Platine (1) nach einem der Ansprüche 3 oder 4,
**dadurch gekennzeichnet,**
**dass** der Kopplungsbereich (9) an einem vom Anschlussbereich (10) entfernten Ende (12) an den Steuerbereich (8) und/oder an den Leistungsbereich (7) angrenzt.

6. Bestückte Platine (1) nach einem der vorhergehenden Ansprüche,
**dadurch gekennzeichnet,**
**dass** der Platinenkörper (2) im Leistungsbereich (7) Kupferelemente (18) aufweist.

7. Bestückte Platine (1) nach einem der vorhergehenden Ansprüche,
**dadurch gekennzeichnet,**
**dass** die bestückte Platine (1) und/oder der Platinenkörper (2) einstückig ausgebildet ist.

8. Bestückte Platine (1) nach einem der vorhergehenden Ansprüche,
**dadurch gekennzeichnet,**
**dass** die ersten Stromanschlüsse (13) und/oder zweiten Stromanschlüsse (14) als Steckverbinder ausgebildet sind.

9. Bestückte Platine (1) nach einem der vorhergehenden Ansprüche,
**dadurch gekennzeichnet,**
- **dass** die Platine (1) zur Verwendung in einem ein Niedervolt-Bordnetz und ein Hochvolt-Bordnetz umfassenden dualen Bordnetz adaptiert ist, so dass die ersten Stromanschlüsse (13) des Leistungsbereichs (7) mit einer relativ hohen Spannung versorgt werden, während die zweiten Stromanschlüsse (14) des Steuerbereichs (8) mit einer relativ niedrigen Spannung versorgt werden, dass bei der für die Verwendung im dualen Bordnetz adaptierte Platine (1) die Kopplungsleiterbahnen (20), unterbrochen sind.

10. Bestückte Platine (1) nach einem der vorhergehenden Ansprüche,
**dadurch gekennzeichnet,**
- **dass** die Platine (1) zur Verwendung in einem Niedervolt-Bordnetz adaptiert ist, so dass die ersten Stromanschlüsse (13) des Leistungsbereichs (7) und die zweiten Stromanschlüsse (14) des Steuerbereichs (8) mit einer relativ niedrigen Spannung versorgt werden.

## Claims

1. Populated board (1) for an electrical on-board network (16) of a motor vehicle (17),
- having a continuous board body (2) on which electronic power components (3), which form a power circuit (5), and electronic control components (4), which form a control circuit (6), are arranged and interconnected,
- wherein, on the board body (2), a contiguous power region (7), in which all power components (3) are arranged, and a contiguous control region (8) are formed, in which all control components (4) are arranged,
- wherein moreover, on the board body (2), a contiguous coupling region (9) is formed in which terminals (19) for at least one electrical coupling component (15) are provided for electrically coupling the control circuit (6) to the power circuit (5),
- wherein, on the board body (2), coupling conductor paths (20) are formed for electrically coupling the control circuit (6) to the power circuit (5),
- wherein the coupling conductor paths (20) run through the coupling region (9),
**characterised in that**
- first current terminals (13) for supplying current to the power circuit (5) are arranged in the power region (7),
- second current terminals (14) for supplying current and for controlling the control circuit (6) are arranged in the control region (8),
- no coupling component (15) is connected to the terminals (19) in the coupling region (9) and the control circuit (6) is coupled to the power circuit (5) by the coupling conductor paths (20),
- the power circuit (5) and the control circuit (6) are designed for a current supply with a common voltage level.

2. Populated board (1) according to claim 1,
**characterised in that**
the coupling region (9) adjoins on the one hand directly on the power region (7) and on the other hand directly on the control region (8).

3. Populated board (1) according to claim 1 or 2,
**characterised in that**
the first current terminals (13) and the second current terminals (14) are arranged next to one another in a continuous terminal region (10) which extends partially in the power region (7) and partially in the control region (8).

4. Populated board (1) according to claim 3,
**characterised in that**
the terminal region (10) is arranged in an edge region (11) of the board body (2).

5. Populated board (1) according to any of claims 3 or 4,
**characterised in that**
the coupling region (9) adjoins on the control region (8) and/or on the power region (7) at an end (12) distant from the terminal region (10).

6. Populated board (1) according to any of the preceding claims,
**characterised in that**
the board body (2) has copper elements (18) in the power region (7).

7. Populated board (1) according to any of the preceding claims,
**characterised in that**
the populated board (1) and/or the board body (2) is formed integrally.

8. Populated board (1) according to any of the preceding claims,
**characterised in that**
the first current terminals (13) and/or second current terminals (14) are formed as plug connectors.

9. Populated board (1) according to any of the preceding claims,
**characterised in that**
- the board (1) is adapted for use in a dual on-board network comprising a low-voltage on-board network and a high-voltage on-board network, such that the first current terminals (13) of the power region (7) are supplied with a relatively high voltage, while the second current terminals (14) of the control region (8) are supplied with a relatively low voltage,
in the case of the board (1) adapted for the use in the dual on-board network, the coupling conductor paths (20) are interrupted.

10. Populated board (1) according to any of the preceding claims,
**characterised in that**
- the board (1) is adapted for use in a low-voltage on-board network, such that the first current terminals (13) of the power region (7) and the second current terminals (14) of the control region (8) are supplied with a relatively low voltage.

## Revendications

1. Platine équipée (1) pour un réseau de bord électrique (16) d'un véhicule automobile (17),
- avec un corps de platine d'un seul tenant (2), sur lequel sont disposés et interconnectés des composants de puissance électroniques (3), qui forment un circuit de puissance (5), et des composants de commande électroniques (4), qui forment un circuit de commande (6),
- dans laquelle une zone de puissance d'un seul tenant (7), dans laquelle sont disposés tous les composants de puissance (3), et une zone de commande d'un seul tenant (8), dans laquelle sont disposés tous les composants de commande (4), sont formées sur le corps de platine (2),
- dans laquelle une zone de couplage d'un seul tenant (9) est en outre formée sur le corps de platine (2), dans laquelle des connexions (19) pour au moins un composant de couplage électrique (15) pour coupler électriquement le circuit de commande (6) au circuit de puissance (5) sont prévues,
- dans laquelle des pistes conductrices de couplage (20) pour coupler électriquement le circuit de commande (6) au circuit de puissance (5) sont formées sur le corps de platine (2),
- dans laquelle les pistes conductrices de couplage (20) traversent la zone de couplage (9),
**caractérisée en ce que**
- de premières connexions électriques (13) pour l'alimentation électrique du circuit de puissance (5) sont disposées dans la zone de puissance (7),
- des secondes connexions électriques (14) pour l'alimentation électrique et pour la commande du circuit de commande (6) sont disposées dans la zone de commande (8),
- aucun composant de couplage (15) n'est relié aux connexions (19) dans la zone de couplage (9) et le circuit de commande (6) est couplé au circuit de puissance (5) par les pistes conductrices de couplage (20),
- le circuit de puissance (5) et le circuit de commande (6) sont conçus pour une alimentation électrique avec un niveau de tension commun.

2. Platine équipée (1) selon la revendication 1,
**caractérisée en ce que**
la zone de couplage (9) est d'une part directement adjacente à la zone de puissance (7) et d'autre part directement adjacente à la zone de commande (8).

3. Platine équipée (1) selon la revendication 1 ou 2,
**caractérisée en ce que**
les premières connexions électriques (13) et les secondes connexions électriques (14) sont disposées côte à côte dans une zone de connexion d'un seul tenant (10) qui s'étend partiellement dans la zone de puissance (7) et partiellement dans la zone de commande (8).

4. Platine équipée (1) selon la revendication 3,
**caractérisée en ce que**
la zone de connexion (10) est disposée dans une zone de bord (11) du corps de platine (2).

5. Platine équipée (1) selon l'une quelconque des revendications 3 ou 4,
**caractérisée en ce que**
la zone de couplage (9) est adjacente à la zone de commande (8) et/ou à la zone de puissance (7) à une extrémité (12) éloignée de la zone de connexion (10).

6. Platine équipée (1) selon l'une quelconque des revendications précédentes,
**caractérisée en ce que**
le corps de platine (2) présente des éléments en cuivre (18) dans la zone de puissance (7).

7. Platine équipée (1) selon l'une quelconque des revendications précédentes,
**caractérisée en ce que**
la platine équipée (1) et/ou le corps de platine (2) est formé d'un seul tenant.

8. Platine équipée (1) selon l'une quelconque des revendications précédentes,
**caractérisée en ce que**
les premières connexions électriques (13) et/ou les secondes connexions électriques (14) sont conçues en tant que connecteurs enfichables.

9. Platine équipée (1) selon l'une quelconque des revendications précédentes, **caractérisée en ce que**
- la platine (1) est adaptée pour être utilisée dans un double réseau de bord comprenant un réseau de bord basse tension et un réseau de bord haute tension, de sorte que les premières connexions électriques (13) de la zone de puissance (7) sont alimentées avec une tension relativement élevée, tandis que les secondes connexions électriques (14) de la zone de commande (8) sont alimentées avec une tension relativement faible,
en ce qui concerne la platine (1) adaptée pour être utilisée dans le double réseau de bord, les pistes conductrices de couplage (20) sont interrompues.

10. Platine équipée (1) selon l'une quelconque des revendications précédentes, **caractérisée en ce que**
- la platine (1) est adaptée pour être utilisée dans un réseau de bord basse tension, de sorte que les premières connexions électriques (13) de la zone de puissance (7) et les secondes connexions électriques (14) de la zone de commande (8) sont alimentées avec une tension relativement faible.
